# EUROPEAN PATENT SPECIFICATION

(11) **EP 3 372 698 B1**
(45) Date of publication and mention of the grant of the patent: **20.01.2021**
(21) Application number: 18158292.5
(22) Date of filing: 23.02.2018
(51) Int. Cl.: C22C 3/00

(54) **ALUMINUM CLAD SHEET AND METHOD FOR MANUFACTURING THE SAME**
ALUMINIUMPLATTIERTES BLECH UND VERFAHREN ZUR HERSTELLUNG DAVON
FEUILLE D'ALUMINIUM REVÊTUE ET SON PROCÉDÉ DE FABRICATION

(30) Priority: 08.03.2017 KR 20170029503
(43) Date of publication of application: 12.09.2018
(73) Proprietor: Samsung Electronics Co., Ltd., Suwon-si, Gyeonggi-do 16677 (KR)
(72) Inventor: JEON, Chang-Woo, 16677 Suwon-si, (KR); MOON, Su-Dong, 16677 Suwon-si, (KR); PARK, Jin-Man, 16677 Suwon-si, (KR); SIM, Jae-Won, 16677 Suwon-si, (KR)
(74) Representative: HGF

(56) References cited:
- WO-A1-2012/059505
- ZHANG WEIWEN ET AL: "Fabrication of aluminum composites with gradient cladding interface by continuous casting", PROCEEDINGS OF [A] SYMPOSIA HELD DURING [THE] TMS 2008 ANNUAL MEETING & EXHIBITION, NEW ORLEANS, LA, UNITED STATES, MAR. 9-13, 2008 (2008), 213-218. EDITOR(S): YIN, WEIMIN, MINERALS, METALS & MATERIALSSOCIETY, WARRENDALE, PA, 1 January 2008 (2008-01-01), pages 213-218, XP009505055,
- ILLARIONOV S YU ET AL: "Increase of corrosion resistance of welded joints of high-strength aluminium alloys by explosion cladding", THE PATON WELDING JOURNAL, E. O. PATON WELDING INSTITUE, KIEV, no. 2, 1 January 2005 (2005-01-01), pages 48-50, XP009505043, ISSN: 0957-798X
- P Oberhauser: "Optimizing the Cladding Composition on 7xxx Alloys Used for Transportation and Aircraft Applications", ASST 2012, Sorrento (Italy), 30 May 2012, 30 May 2012 (2012-05-30), pages 1-16, XP055470171, Retrieved from the Internet: URL:https://www.researchgate.net/publicati on/284725683_Optimizing_the_Cladding_Compo sition_on_7xxx_Alloys_Used_for_Transportat ion_and_Aircraft_Applications [retrieved on 2018-04-24]
- N.N.: "Hochfester Aluminiumwerkstoff für Leichtbau-Wärmetauscher", , 1 March 2012 (2012-03-01), XP55470201, Retrieved from the Internet: URL:https://www.amag.at/fileadmin/user_upl oad/amag/Downloads/AluReport/DE/AR-2012-3- DE-AluReport_3_12_DT_S10-11.pdf

## Description

### TECHNICAL FIELD

The present invention relates to an electronic device, comprising a housing formed of an aluminum clad sheet which is anodizable, as it is defined in the appended claims.

### DISCUSSION OF RELATED ART

Aluminum is a light metal which is commonly used in industrial applications for a myriad of purposes. Aluminum alloys are alloys in which aluminum (Al) is the predominant metal. Typical alloying elements to accompany the aluminum are copper, magnesium, manganese, silicon, tin and zinc.

Due to their remarkable specific strength, most aluminum alloys have a wide range of applications in the aviation industry, and their superiority in thermal conductivity, reflectivity, corrosion resistance, and/or workability leads to their considerable demand for military or civilian purposes, e.g., defense or civilian articles such as automobiles and aircrafts. There are two principal classifications for aluminum alloys, namely casting alloys and wrought alloys, both of which are further subdivided into the categories of heat-treatable and non-heat-treatable. Wrought alloys are commonly used for, e.g., extrusions, rolling, or forging, and casting alloys are commonly used for sand casting or die casting.

Using anodizing techniques, aluminum alloy surfaces can be manipulated to develop an even, protective layer of aluminum oxide (Al2O3) up to a few tens of micrometers. The high hardness of the layer contributes to give aluminum enhanced abrasion resistance.

Among wrought alloys, 7xxx series (e.g., Al-Zn series) are used as aircraft material have high strength (more than 350MPa). They may be used in various aircraft engineering application.

As more portable electronic devices, e.g., smartphones or laptop computers, become larger and thinner, they may be subject to greater physical stress, e.g. when the devices are bent. As such, there is an attempt to adopt 7xxx series alloys, which have higher specific strengths than other aluminum alloys, as material for the housings of the electronic devices.

Despite their superior mechanical properties, 7xxx series aluminum alloys suffer from limited applications due to lower corrosion resistance and surface treatability than the other alloys. For example, with less pure aluminum (Al), 7xxx series aluminum alloys may suffer from growths of uneven oxide layers or discolorations or spots when it is anodized. Thus, low-purity aluminum may not produce uniform metallic texture and satisfactory color, rendering it difficult to adopt as housing material for electronic devices.

The above information is presented as background information only to assist with an understanding of the present disclosure. No determination has been made, and no assertion is made, as to whether any of the above might be applicable as prior art with regard to the present disclosure. Zhang weiwen et al: "Fabrication of aluminium composites with gradient cladding interface by continuous casting", Proceedings of symposia sponsosed by the Light Metals Division of The Minerals, Metals & Materials Society (TMS), Louisiana, USA, March 9-13 2008 discloses a method to produce bimetallic composites with gradient cladding interface named double-stream-pouring contiunuous casting (DSPCC). Illarionov et al: "Increase of corrosion resistance of welded joints of high-strength aluminium alloys by explosion cladding", The Paton Welding Journal, pages 48-50, 2/2005 discloses an evaluation of the efficiency of using explosion welding for cladding of friction stir welding joints of high-strength aluminium alloys with technically pure aluminium for increasing of their corrosion resistance. AluReport March 2012, Automotive discloses high-strength aluminium material for light weight heat exchanger applications.

### SUMMARY

An embodiment of the present invention is defined in claim 1. According to an example of the present disclosure, multi-layer aluminum clad sheets may be produced using an aluminum alloy having superior anodizing properties as a coat material for a 7xxx-series aluminum alloy.

According to an exampleof the present disclosure, a clad sheet may use a 7xxx-series aluminum alloy in the base area so that the clad sheet has a higher strength and a 1xxx-series aluminum alloy having superior anodizing properties or a 6xxx-series aluminum alloy which is also anodizable in the coat area.

According to an exampleof the present disclosure, a method for manufacturing an aluminum clad sheet may enhance the adhesion strength of the clad sheet by employing thermal treatment and may age-harden the clad sheet without deteriorating strength, thereby achieving superior surface and engineering properties.

According to an exampleof the present disclosure, an electronic device comprising a housing formed of an anodizable aluminum clad sheet may comprise a base material including a 7xxx-series aluminum alloy and a coat material including a 6xxx-series aluminum alloy or a 1xxx-series aluminum alloy disposed on one or both front and back surfaces of the base material.

The 7xxx-series aluminum alloy includes 4.0% to 8.0% of zinc (Zn) relative to a total weight of the aluminum clad sheet, 1.0% to 3.0% of magnesium (Mg), and at least one other impurity.

According to an exampleof the present disclosure, a method for manufacturing an aluminum clad sheet which is anodizable may comprise preparing a 7xxx-series aluminum alloy and a 6xxx-series aluminum alloy or a 1xxx-series aluminum alloy, placing the 7xxx-series aluminum alloy as a base material and overlaying the 6xxx-series aluminum alloy or the 1xxx-series aluminum alloy, as a coat material, on one or both front and back surfaces of the base material, heating the overlaid layers at 480 °C to 520 °C to soften and rolling the softened layers to join together, forging and shaping the softened layers, performing solution treatment on the layers, the solution treatment including heating the layers at 520 °C to 540 °C for 30 minutes or more and then water cooling the layers, and performing age-hardening on the solution-treated layers, the age-hardening including heating the layers at the solution-treated layers at 80 °C to 180 °C for eight hours or more and then air-cooling the layers.

Other aspects, advantages, and salient features of the disclosure will become apparent to those skilled in the art from the following detailed description, which, taken in conjunction with the annexed drawings, discloses exemplary embodiments of the disclosure.

### BRIEF DESCRIPTION OF THE DRAWINGS

A more complete appreciation of the present disclosure and many of the attendant aspects thereof will be readily obtained as the same becomes better understood by reference to the following detailed description when considered in connection with the accompanying drawings, wherein:
Fig. 1 is a cross-sectional view of a side portion of a multi-layer clad sheet 100 using an aluminum alloy according to an example of the present disclosure;
Fig. 2 is a photograph showing a cross section of the multi-layer aluminum clad sheet 100 of Fig. 1, according to an exampleof the present disclosure;
Fig. 3 is a cross-sectional view of a side portion of a multi-layer (three-layer) clad sheet 200 using an aluminum alloy according to an exampleof the present disclosure;
Fig. 4 is a cross-sectional view of a side portion of a multi-layer (three-layer) clad sheet 300 using an aluminum alloy according to an exampleof the present disclosure;
Fig. 5 is a flowchart illustrating a method for manufacturing a clad sheet using an aluminum alloy according to an example of the present disclosure; and
Fig. 6 is a flow diagram illustrating operations of a method for manufacturing a clad sheet using an aluminum alloy as shown in Fig. 5.
Fig. 7 is an exploded perspective view illustrating an electronic device 400 including a housing 410 made up of an aluminum alloy according to an example of the present disclosure.

Throughout the drawings, like reference numerals will be understood to refer to like parts, components, and structures.

### DETAILED DESCRIPTION

Hereinafter, exampleof the present disclosure are described with reference to the accompanying drawings. However, it should be appreciated that the present disclosure is not limited to the example and the terminology used herein, and all changes and/or equivalents or replacements thereto also belong to the scope of the present disclosure. It is to be understood that the singular forms "a," "an," and "the" include plural references unless the context clearly dictates otherwise. As used herein, the terms "A or B" or "at least one of A and/or B" may include all possible combinations of A and B. As used herein, the terms "first" and "second" may modify various components regardless of importance and/or order and are used to distinguish a component from another without limiting the components. It will be understood that when an element (e.g., a first element) is referred to as being (operatively or communicatively) "coupled with/to," or "connected with/to" another element (e.g., a second element), it can be coupled or connected with/to the other element directly or via a third element.

As used herein, the terms "configured to" may be interchangeably used with other terms, such as "suitable for," "capable of," "modified to," "made to," "adapted to," "able to," or "designed to" in hardware or software in the context. Rather, the term "configured to" may mean that a device can perform an operation together with another device or parts. For example, the term "processor configured (or set) to perform A, B, and C" may mean a generic-purpose processor (e.g., a CPU or application processor) that may perform the operations by executing one or more software programs stored in a memory device or a dedicated processor (e.g., an embedded processor) for performing the operations.

According to an example of the present disclosure, a multi-layer clad sheet using an aluminum alloy is applicable to case frames or bezels of electronic devices.

For example, examples of the electronic device according to examples of the present disclosure may include at least one of a smartphone, a tablet personal computer (PC), a mobile phone, a video phone, an e-book reader, a desktop PC, a laptop computer, a netbook computer, a workstation, a server, a personal digital assistant (PDA), a portable multimedia player (PMP), a MP3 player, a medical device, a camera, or a wearable device. The wearable device may include at least one of an accessory-type device (e.g., a watch, a ring, a bracelet, an anklet, a necklace, glasses, contact lenses, or a head-mounted device (HMD)), a fabric- or clothes-integrated device (e.g., electronic clothes), a body attaching-type device (e.g., a skin pad or tattoo), or a body implantable device.Examples of the smart home appliance may include at least one of a television, a digital video disk (DVD) player, an audio player, a refrigerator, an air conditioner, a cleaner, an oven, a microwave oven, a washer, a drier, an air cleaner, a set-top box, a home automation control panel, a security control panel, a TV box (e.g., Samsung HomeSync™, Apple TV™, or Google TV™) , a gaming console (Xbox™, PlayStation™), an electronic dictionary, an electronic key, a camcorder, or an electronic picture frame.

According to an example of the present disclosure, the electronic device may include at least one of various medical devices (e.g., diverse portable medical measuring devices (a blood sugar measuring device, a heartbeat measuring device, or a body temperature measuring device), a magnetic resource angiography (MRA) device, a magnetic resource imaging (MRI) device, a computed tomography (CT) device, an imaging device, or an ultrasonic device), a navigation device, a global navigation satellite system (GNSS) receiver, an event data recorder (EDR), a flight data recorder (FDR), an automotive infotainment device, an sailing electronic device (e.g., a sailing navigation device or a gyro compass), avionics, security devices, vehicular head units, industrial or home robots, drones, automatic teller's machines (ATMs), point of sales (POS) devices, or internet of things (IoT) devices (e.g., a bulb, various sensors, a sprinkler, a fire alarm, a thermostat, a street light, a toaster, fitness equipment, a hot water tank, a heater, or a boiler). According to various examples of the disclosure, examples of the electronic device may at least one of part of a piece of furniture, building/structure or vehicle, an electronic board, an electronic signature receiving device, a projector, or various measurement devices (e.g., devices for measuring water, electricity, gas, or electromagnetic waves). According to examples of the present disclosure, the electronic device may be flexible or may be a combination of the above-enumerated electronic devices. According to an example of the disclosure, the electronic devices are not limited to those described above.

As used herein, the term "manufacturer" may denote a human or a device (e.g., an artificial intelligent electronic device) that manufactures electronic devices or clad sheets.

According to an example of the present disclosure, wrought aluminum (Al) alloysmay be shaped in various shapes using molds. In one example, casting using molds may be done with an anodizing surface treatment so that the molded alloy may have a decorative outer look with superior abrasion resistance and corrosion resistance and various colors.

An example of the present disclosure is an anodizable aluminum clad sheet with a specified composition ratio. Also provided in the present disclosure is a method for manufacturing the anodizable aluminum clad sheet. The adhesion strength of the clad sheet may be enhanced by adhesion and thermal treatment. A clad sheet with superior surface and engineering properties may be obtained by age-hardening. Doing so may be lower the strength of the clad sheet.

According to an example of the present disclosure, the disclosed aluminum alloy may be used for interior/exterior parts of portable electronic devices, where these devices are required to be slim and strong. In one example, such an electronic device may include a display.

A product produced by anodizing an aluminum alloy according to various examples of the present disclosure may have various types of color treatability and good post-treatability, allowing for easier surface treatment, e.g., plating or painting.

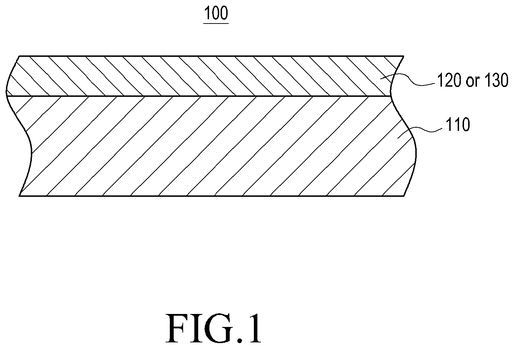

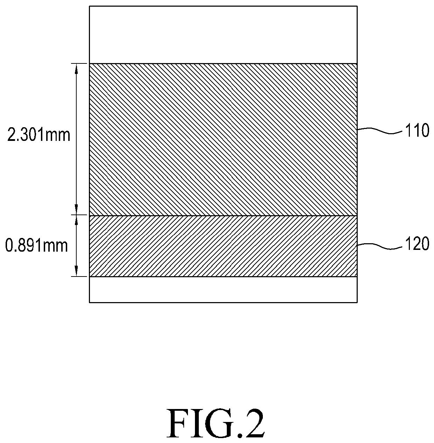

Fig. 1 is a cross-sectional view of a side portion of a multi-layer clad sheet 100 using an aluminum alloy according to an example of the present disclosure. Fig. 2 is a photograph showing a cross section of the multi-layer aluminum clad sheet 100 of Fig. 1, according to an example of the present disclosure.

Referring to Figs. 1 and 2, the multi-layer clad sheet 100 using an aluminum alloy may have a 7xxx-series aluminum alloy 110 in a base area and a 6xxx-series aluminum alloy 120 or a 1xxx-series aluminum alloy 130 (an alloy having a purity of 99% or more) in a coat area. The clad sheet including the base of the 7xxx-series aluminum alloy 110 and the coat of the 6xxx-series aluminum alloy 120 or 1xxx-series aluminum alloy 130 may be anodized so that it has superior surface properties.

Table 1 below presents composition ratios for the coat aluminum alloy and the base aluminum alloy used in the aluminum clad sheet 100 according to an example of the present disclosure.

**[Table 1]**

| Samples | Composition (impurities other than Al) | | | | | | | |
|---|---|---|---|---|---|---|---|---|
| (Weight%) | Si | Fe | Cu | Mn | Mg | Cr | Zn | Ti |
| Coat material (A16061) | 0.40-0.80 | <=0.7 | 0.15-0.40 | <=0.15 | 0.8-1.2 | 0.04-0.35 | <=0.25 | <=0.15 |
| Base material (A17075) | <=0.4 | <=0.5 | 1.2-2.0 | <=0.3 | 2.1-2.9 | 0.18- 0.28 | 5.1-6.1 | <=0.2 |

According to an example of the present disclosure, the 7xxx-series aluminum alloy 110 used in the base area of the aluminum clad sheet 100 has the higher strength (e.g., 450MPa or more).

Referring to Table 1 above, according to an example of the present disclosure, the 7xxx-series aluminum alloy 110 used in the base area may be an Al-Zn-Mg alloy including aluminum (Al), zinc (Zn), and magnesium (Mg). For example, the 7xxx-series aluminum alloy 110 may be the Al 7075 alloy with very high strength. In addition, when the 7xxx-series aluminum alloy is welded to another structure, the portion of the alloy treated by heat, due to age-hardening, may restore to a strength close to the original strength of the alloy after welding, thereby the alloy presents superior joint efficiency.

According to an example of the present disclosure, the composition ratio for the 7xxx-series aluminum alloy 110 is as follows: 87.5% to 91.5% by weight of Al, 4.0% to 8.0% of Zinc (Zn) by weight, 3.0% or less of Magnesium (Mg) by weight(i.e. 1.0% to 3.0% f Magnesium (Mg) by weight), and at least one other impurity. The impurities may include at least one of silicon (Si), iron (Fe), copper (Cu), manganese (Mn), chromium (Cr), and titanium (Ti). For example, the impurities may be contained in relatively tiny quantities, e.g., 0.40% by weight or less of Si, 0.50% by weight or less of Fe, 1.2% to 2.0% by weight of Cu, 0.30% by weight or less of Mn, 0.18% to 0.28% by weight of Cr, and 0.20% by weight or less of Ti.

According to an example of the present disclosure, the 7xxx-series aluminum alloy 110 may be an alloy having a yield strength of, at least, 400MPa. For example, in the above-described Al-Zn-Mg alloy containing Zn and Mg, an MgZn2 phase may develop, thereby giving the multi-layer aluminum clad sheet high strength. According to an example of the present disclosure, Mg may enhance corrosion resistance, strength, ductility, low weight, and machinability of the alloy. As another example, the 1.0 % to 2.0 % by weight of Cu in the Al-Zn-Mg-Cu alloy may be used to give the multi-layer aluminum clad sheet high strength.

According to an example of the present disclosure, the 6xxx-series aluminum alloy 120 used in the coat area of the multi-layer aluminum clad sheet 100 has an intermediate strength among aluminum alloys, superior corrosion resistance, weldability, and cold workability. Some of these 6xxx-series aluminum alloys also have superior anodizability and extrudability.

Referring to Table 1 above, according to an example of the present disclosure, the 6xxx-series aluminum alloy 120 used in the coat area may be an Al-Mg-Si alloy including aluminum (Al), silicon (Si), and magnesium (Mg).

According to an example of the present disclosure, the composition ratio for the 6xxx-series aluminum alloy 120 is as follows: 97.25% to 98.21 % of Al by weight, 0.4% to 1.4 % of Si by weight, 0.6% to 1.3 % of Mg by weight, and at least one other impurity. The other impurities may include at least one of iron (Fe), copper (Cu), manganese (Mn), chromium (Cr), zinc (Zn), and titanium (Ti). For example, the impurities may be contained in relatively tiny quantities, e.g., 0.70 % or less by weight of Fe, 0.15% to 0.40% by weight of Cu, 0.15% or less by weight of Mn, 0.04% to 0.35% by weight of Cr, 0.25% or less by weight of Zn, and 0.15% or less by weight of Ti.

According to an example of the present disclosure, the 6xxx-series aluminum alloy 120 may be an AL 6061 alloy having a yield strength of, at least, 250MPa. As another example, an Al-Mg-Si alloy containing 1% or less by weight of Cu may be used for anodizing.

According to an example of the present disclosure, besides the 6xxx-series aluminum alloy 120, the 1xxx-series aluminum alloy 130 may be used in the coat area of the multi-layer aluminum clad sheet 100. The 1xxx-series aluminum alloy 130 used in the coat area may be an alloy containing pure aluminum with a purity of 99% or more. The 1% or less of the impurities may be primarily Fe and Si. In the 1xxx-series aluminum alloy 130, less impurities may mean better corrosion resistance and better surface treatability.

According to an example of the present disclosure, properties of the 1xxx-series aluminum alloy 130 include high joinability at high temperature. For example, the 1xxx-series aluminum alloy 130 has superior easy-to-roll and anodizing properties due to the fact that it is 99% or more of pure Al. Since the 1xxx-series aluminum alloy 130 is not subject to age-hardening and its own strength is low, when the 1xxx-series aluminum alloy 130 is formed in the coat area instead of the 6xxx-series aluminum alloy 120, the 1xxx-series aluminum alloy 130 may be thinner.

According to an example of the present disclosure, in the multi-layer clad sheet 100, the base area may take up 50% to 90% of the thickness of the entire clad sheet 100.

For example, where the aluminum clad sheet 100 uses the 7xxx-series aluminum alloy 110 in the base area and the 6xxx-series aluminum alloy 120 in the coat area, the 7xxx-series aluminum alloy 110 occupies 50% to 90% of the thickness of the whole clad sheet 100, and the 6xxx-series aluminum alloy 120, conversely, takes up 10% to 50% of the thickness of the whole clad sheet 100.

As another example, where the aluminum clad sheet 100 uses the 7xxx-series aluminum alloy 110 in the base area and the 1xxx-series aluminum alloy 130 in the coat area, the 7xxx-series aluminum alloy 110 makes up 80% or more of the thickness of the whole clad sheet 100, and the 1xxx-series aluminum alloy 130 takes up 20% or less of the thickness of the whole clad sheet 100.

According to an example of the present disclosure, after being rolled, the multi-layer clad sheet 100 may undergone thermal treatment. According to an example of the present disclosure, the rolling may be performed in a reduction ratio from 40% to 60%. Where the rolling is performed in a reduction ratio less than 40%, it may be hard to achieve atomic access between the sheets to be joined together, which may reduce the attaching strength of the clad sheet. Where the rolling is conducted in a reduction ratio more than 60%, the rolling of the sheets may be impossible (e.g. the rolling may cause cracking of the sheets).

Thus, where the multi-layer aluminum clad sheet 100 uses the 7xxx-series aluminum alloy 110 in the base area and the 6xxx-series aluminum alloy 120 in the coat area, the rolling may be performed in a reduction ratio of 40% or more. As another example, where the multi-layer aluminum clad sheet 100 uses the 7xxx-series aluminum alloy 110 in the base area and the 1xxx-series aluminum alloy 130 in the coat area, the rolling may be performed in a reduction ratio from 10% to 20%. Since the 1xxx-series aluminum alloy 130 has a low strength on its own, it may be rolled in a relatively higher reduction ratio than the 6xxx-series aluminum alloy 120.

According to an example of the present disclosure, the multi-layer aluminum clad sheet 100 is implemented in a multi-layered structure including the 7xxx-series aluminum alloy 110 as base material and the 6xxx-series aluminum alloy 120 or the 1xxx-series aluminum alloy 130 as coat material. Thus, the multi-layer aluminum clad sheet 100 may inherit the advantages from both the types of alloys. As another example, it is possible to manufacture clad sheets with high yield strength and ductility, and superior surface treatability by optimizing the thickness ratio of the base material and the coat material.

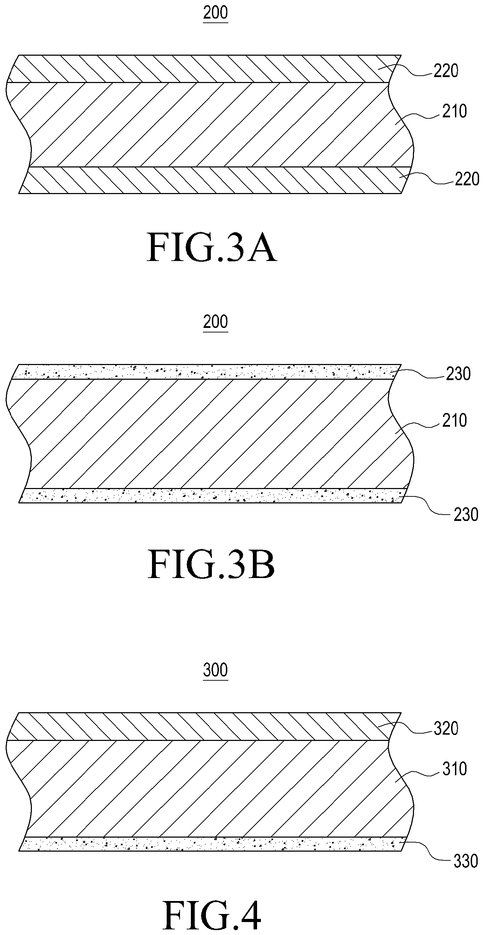

Fig. 3 is a cross-sectional view of a side portion of a multi-layer (three-layer) clad sheet 200 using an aluminum alloy according to an example of the present disclosure. The aluminum clad sheet 200 of Fig. 3 may be wholly or partially identical in structure to the clad sheet 100 of Figs. 1 and 2.

According to an example of the present disclosure, the multi-layer clad sheet 200 may have a 7xxx-series aluminum alloy 210 in a base area and a 6xxx-series aluminum alloy 220 or a 1xxx-series aluminum alloy 230 (an alloy having a purity of 99% or more) in one or more coat areas.

Referring to Fig. 3A, the 7xxx-series aluminum alloy 210 used in the base area of the multi-layer aluminum clad sheet 200 may be an Al-Zn-Mg alloy having the higher strength and including aluminum (Al), zinc (Zn), and magnesium (Mg). According to an example of the present disclosure, the 6xxx-series aluminum alloy 220 used in the coat area of the multi-layer aluminum clad sheet 200 may be an Al-Mg-Si alloy having an intermediate strength among aluminum alloys and including aluminum (Al), magnesium (Mg), and silicon (Si).

According to an example of the present disclosure, the multi-layer aluminum clad sheet 200 according to Fig. 3A may have the 6xxx-series aluminum alloy 220 disposed on the front surface and the back surface of the 7xxx-series aluminum alloy 210. Thus, the multi-layer aluminum clad sheet 200 may include three aluminum alloy layers. Accordingly, the 6xxx-series aluminum alloys 220 are disposed in the outer areas of the multi-layer aluminum clad sheet 200, allowing the multi-layer aluminum clad sheet 200 to have suitable exterior properties. The description made above in connection with Figs. 1 and 2 may apply here.

Referring to Fig. 3B, the 7xxx-series aluminum alloy 210 used in the base area of the multi-layer aluminum clad sheet 200 may be an Al-Zn-Mg alloy having the higher strength and including aluminum (Al), zinc (Zn), and magnesium (Mg). According to an example of the present disclosure, the 1xxx-series aluminum alloy 230 used in the coat area of the multi-layer aluminum clad sheet 200 may be a pure aluminum alloy with a purity of 99% or more.

According to an example of the present disclosure, the multi-layer aluminum clad sheet 200 may have the 1xxx-series aluminum alloy 230 disposed on the front surface and the back surface of the 7xxx-series aluminum alloy 210. Thus, the multi-layer aluminum clad sheet 200 may include three aluminum alloy layers. Accordingly, the 1xxx-series aluminum alloys 230 are disposed in the outer areas of the multi-layer aluminum clad sheet 200, allowing the multi-layer aluminum clad sheet 200 to have suitable exterior properties. The description made above in connection with Figs. 1 and 2 may apply here.

Fig. 4 is a cross-sectional view of a side portion of a multi-layer (three-layer) clad sheet 300 using an aluminum alloy according to an example of the present disclosure. The aluminum clad sheet 300 of Fig. 4 may be wholly or partially identical in structure to the clad sheet 100 of Figs. 1 and 2.

According to an example of the present disclosure, the multi-layer clad sheet 300 may have a 7xxx-series aluminum alloy 310 in a base area and a 6xxx-series aluminum alloy 320 or a 1xxx-series aluminum alloy 330 (an alloy having a purity of 99% or more) in one or more coat areas.

Referring to Fig. 4, the multi-layer aluminum clad sheet 300 may have the 6xxx-series aluminum alloy 320 disposed on the front surface of the 7xxx-series aluminum alloy 310 and the 1xxx-series aluminum alloy 330 on back surface of the 7xxx-series aluminum alloy 310. Thus, the multi-layer aluminum clad sheet 200 may include three aluminum alloy layers. The 6xxx-series aluminum alloy 320 or 1xxx-series aluminum alloy 330 is disposed in the outer areas of the multi-layer aluminum clad sheet 300, allowing the multi-layer aluminum clad sheet 200 to have suitable exterior properties. The description made above in connection with Figs. 1 and 2 may apply here.

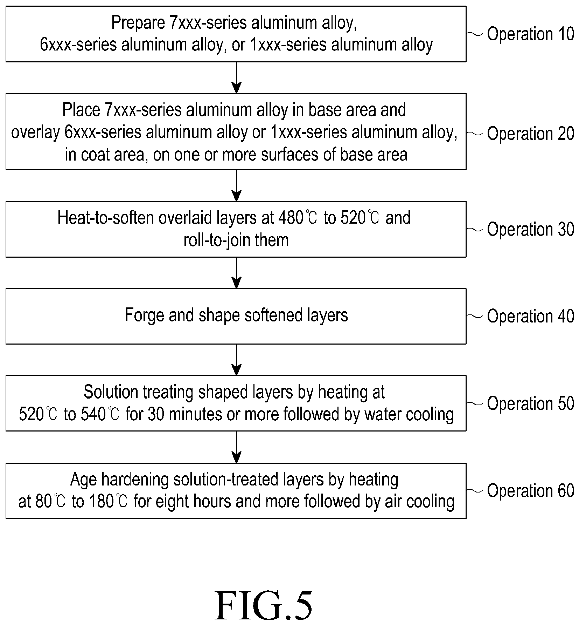

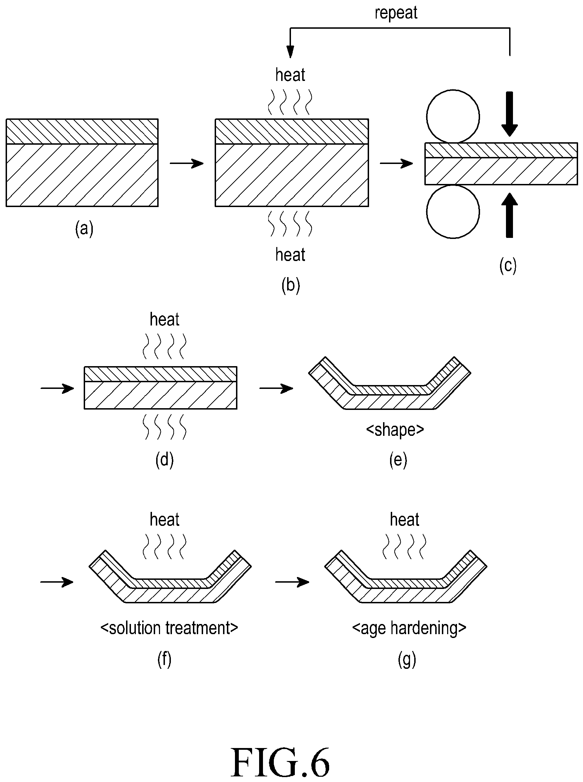

Fig. 5 is a flowchart illustrating a method for manufacturing a clad sheet using an aluminum alloy according to an example of the present disclosure. Fig. 6 is a flow diagram illustrating operations of a method for manufacturing a clad sheet using an aluminum alloy as shown in Fig. 5. The 7xxx-series aluminum alloy, 6xxx-series aluminum alloy, and 1xxx-series aluminum alloy of the aluminum clad sheet shown in Figs. 5 and 6 may wholly or partially be the same in structure as the 7xxx-series aluminum alloy 110, 6xxx-series aluminum alloy 120, and 1xxx-series aluminum alloy 130 of the multi-layer aluminum clad sheet 100 shown in Fig. 1.

Referring to Figs. 1, 5, and 6, in operation 10, the 7xxx-series aluminum alloy 110, the 6xxx-series aluminum alloy 120, and the 1xxx-series aluminum alloy 130 may be prepared to be used in the multi-layer aluminum clad sheet 100.

According to an example of the present disclosure, the prepared 7xxx-series aluminum alloy 110 (e.g., an Al-Zn-Mg alloy) may have a yield strength of 400MPa or more. The prepared 6xxx-series aluminum alloy 120 (e.g., an Al-Mg-Si alloy) may have a yield strength of 250MPa or more.

According to an example of the present disclosure, the composition ratio for the 7xxx-series aluminum alloy 110 may be as follows: 87.0% to 91.0 % of A1 by weight, 5.1% to 6.1 % of Mg by weight, 2.1% to 2.9 % of Mg by weight, and at least one other impurity. As another example, the composition ratio for the 6xxx-series aluminum alloy 120 may be as follows: 97.25% to 98.21 % of A1 by weight, 0.40% to 0.80 % of Si by weight, 0.8% to 1.2 % of Mg by weight, and at least one other impurity. The description made above in connection with Fig. 1 and Table 1 may apply here.

After the multiple aluminum alloys are prepared, the 7xxx-series aluminum alloy 110, the 6xxx-series aluminum alloy 120 and/or the 1xxx-series aluminum alloy 130 may be layered one over another to form a base area and a coat area in the multi-layer aluminum clad sheet 100 in operation 20 as shown in Fig. 5.

According to an example of the present disclosure, the 7xxx-series aluminum alloy 110 may be disposed in the base area, and the 6xxx-series aluminum alloy 120 or 1xxx-series aluminum alloy 130 may be layered on one or both front and back surfaces of the base area. For example, after the 7xxx-series aluminum alloy 110 is disposed, the 6xxx-series aluminum alloy 120 may be layered on one or both surfaces of the 7xxx-series aluminum alloy 110. As another example, after the 7xxx-series aluminum alloy 110 is disposed, the 1xxx-series aluminum alloy 130 may be layered on one or both surfaces of the 7xxx-series aluminum alloy 110. As another example, after the 7xxx-series aluminum alloy 110 is disposed, the 6xxx-series aluminum alloy 120 may be disposed on the front surface of the 7xxx-series aluminum alloy 110 and the 1xxx-series aluminum alloy 130 may be layered on the opposite surface of the 7xxx-series aluminum alloy 110.

According to an example of the present disclosure, although methods for forming in two or three layers have been described above, examples of the present disclosure are not limited thereto. For example, the 6xxx-series aluminum alloys 120 and the 1xxx-series aluminum alloys 130 may be differently arranged on the 7xxx-series aluminum alloy 110 disposed in the base area, e.g., the 6xxx-series aluminum alloys 120 and/or the 1xxx-series aluminum alloys 130, together with the 7xxx-series aluminum alloy 110, may form a clad sheet in four or more layers.

After the plurality of aluminum alloys are formed in layers, the layers may be heated to 450 °C to 520 °C to soften them and may then be subject to rolling, as shown in operation 30 of Fig. 5 and Figs. 6(b) to 6(d).

According to an example of the present disclosure, the clad sheet 100 may be heated at 450 °C to 550 °C for 0.5 hours to 1.5 hours. For example, the clad sheet may be heated for about one hour. The layered sheets, after they are softened, may be hot-rolled so that they join together, as shown in Fig. 6(c). The heat-to-soften operation and the roll-to-join operation may be repeated multiple times until the clad sheet reaches the thickness the manufacturer desires.

According to an example of the present disclosure, the heat-to-soften operation and the roll-to-join operation may be repeated until reaching a reduction ratio of 40% through 60% at room temperature. Where the rolling is performed in a reduction ratio less than 40%, it may be hard to achieve atomic access between the sheets to be joined together, which may reduce the attaching strength of the clad sheet. Where the rolling is conducted in a reduction ratio more than 60%, the rolling of the sheets may be impossible (e.g. the rolling may cause cracking of the sheets).

According to an example of the present disclosure, where the multi-layer aluminum clad sheet 100 uses the 7xxx-series aluminum alloy 110 in the base area and the 6xxx-series aluminum alloy 120 in the coat area, the rolling may be performed in a reduction ratio of 40% or more. As another example, where the multi-layer aluminum clad sheet 100 uses the 7xxx-series aluminum alloy 110 in the base area and the 1xxx-series aluminum alloy 130 in the coat area, the rolling may be performed in a reduction ratio from 10% to 20%. Since the 1xxx-series aluminum alloy 130 has a low strength on its own, it may be rolled in a relatively higher reduction ratio than the 6xxx-series aluminum alloy 120.

A diffusion-bonding/softening operation, as shown in Fig. 6(d) may be performed in which the clad sheet 100 may be heated to a temperature from 450 °C to 550 °C for 10 minutes or more between the rolling processes so that interfacial diffusion bonding may occur to a sufficient degree. For example, the diffusion-bonding/softening operation may heat the layered base sheets at 480 °C to 520 °C for about 15 minutes.

The clad sheet 100 may then be forged and shaped as per operation 40 in Fig. 5 and as shown in Fig. 6(e). The forging and shaping operation may be performed while the clad sheet 100 is heated and softened at 480 °C to 520 °C

According to an example of the present disclosure, in some cases, the forging and shaping operation may be followed by heating for 5 minutes or more and re-forging and re-shaping to shape the clad sheet 100 into an appropriate one. After the forging and shaping operation and/or the re-forging and reshaping operation are performed, heat treatment may be conducted to enhance the strength of the clad sheet.

The shaped clad sheet 100 may be subject to solution treatment involving heating and water cooling as per operation 50 in Fig. 5 and as shown in Fig. 6(f).

Solution treatment is a process that preserves the stability of structures so that structures that are stable at high temperatures are also stable at low temperatures. For example, this treatment heats the structure to a high temperature and then rapidly cools the structure. According to an example of the present disclosure, described is an example where the multi-layer aluminum clad sheet 100 uses the 7xxx-series aluminum alloy 110 in the base area and the 6xxx-series aluminum alloy 120 in the coat area. The 7xxx-series aluminum alloy 110 and the 6xxx-series aluminum alloy 120, although both are precipitation hardening alloys, have different heat treatment times and temperatures due to differences in the type of precipitation phase. Thus, to secure the optimal strength for the clad sheet 100, specific heat treatment conditions are also needed under which the strength of the 7xxx-series aluminum alloy 110 and the strength of the 6xxx-series aluminum alloy 120 may simultaneously be achieved.

Table 2 below presents examples of testing heat treatment conditions in several examples where solution treatment and water cooling heat treatment (operation 50 in Fig. 5) and age hardening (operation 60 in Fig. 5) are performed.

**[Table 2]**

| Samples | T4 heat treatment | | T6 heat treatment | yield strengths (MPa) |
|---|---|---|---|---|
| | solution treatment | water cooling | age hardening | |
| Example 1 | 480°C, 4h (7075) | water cooling | (1) 120°C, 24h (condition 7075) | 372 |
| Example 2 | | | (2) 160°C, 18h (6061, rolling) | 373 |
| Example 3 | | | (3) 180°C, 8h (6061, extrusion) | 337 |
| Example 4 | | | (4) 80°C, 16h + 150°C, 24h (dual treatment) | 402 |
| Example 5 | 520°C, 4h (6061) | | (5) 120°C, 24h (condition 7075) | 393 |
| Example 6 | | | (6) 160°C, 18h (6061, rolling) | 368 |
| Example 7 | | | (7) 180°C, 8h (6061, extrusion) | 333 |
| Example 8 | | | (8) 80°C, 16h + 150°C, 24h (dual treatment) | 410 |
| Comparison example 1 | 502°C, 4h (6061) | water cooling | (1) 120°C, 12h | 321 |
| Comparison example 2 | | | (2) 160°C, 24h | 295 |
| Comparison example 3 | | | (3) 180°C, 18h | 280 |

As shown in Table 2 above, example 1 to example 8 were tested under different conditions.

### <Example 1 to example 4>

A multi-layer aluminum clad sheet 100 formed as per examples 1 to 4 was subjected to solution treatment and water cooling at 480 °C for four hours. Thereafter, age hardening was performed under various different conditions.

### <Example 5 to example 8>

A multi-layer aluminum clad sheet 100 formed as per examples 5 to 8 was subjected to solution treatment and water cooling at 520 °C for four hours. Thereafter, age hardening was performed under various different conditions.

The clad sheet 100 that has undergone the solution treatment may be subject to age hardening using heat treatment as per operation 60 in Fig. 5 and as shown in Fig. 6(g).

Age hardening is a process in which metallic material hardens at a proper temperature for a period of time and changes from its original unstable state to a stable state. In this process, atoms of the metallic material are arranged into metallic crystals. Age hardening include two types: room temperature age hardening and artificial age hardening. The former causes the atoms of the material to move at room temperature, and the latter uses heat to cause atomic movements. According to an example of the present disclosure, an aluminum alloy clad sheet 100 may be manufactured under predetermined heating conditions.

According to an example of the present disclosure, the strength and ductility of the multi-layer aluminum clad sheet 100 may vary depending on different heat treatment conditions. As shown in Table 2 above, example 1 to example 8 were tested under different conditions.

### <First example>

In example 1, the multi-layer aluminum clad sheet 100 which had undergone solution treatment and water cooling at 480 °C for four hours was age-hardened at 120 °C for 24 hours. It could be verified that the resultant multi-layer aluminum clad sheet 100 exhibited a yield strength of 372MPa.

### <Second example>

In example 2, the multi-layer aluminum clad sheet 100 which had undergone solution treatment and water cooling at 480 °C for four hours was age-hardened at 160 °C for 18 hours. It could be verified that the resultant multi-layer aluminum clad sheet 100 exhibited a yield strength of 373MPa.

### <Third example>

In example 3, the multi-layer aluminum clad sheet 100 which had undergone solution treatment and water cooling at 480 °C for four hours was age-hardened at 180 °C for 8 hours. It could be verified that the resultant multi-layer aluminum clad sheet 100 exhibited a yield strength of 337MPa.

### <Example 4>

In example 4, the multi-layer aluminum clad sheet 100 which had undergone solution treatment and water cooling at 480 °C for four hours was subjected to first age-hardening at 80 °C for 16 hours. After the first age hardening, second age hardening was performed at 150 °C for 24 hours. It could be verified that the resultant multi-layer aluminum clad sheet 100 exhibited a yield strength of 402MPa.

### <Example 5>

In example 5, the multi-layer aluminum clad sheet 100 which had undergone solution treatment and water cooling at 520 °C for four hours was age-hardened at 120 °C for 24 hours. It could be verified that the resultant multi-layer aluminum clad sheet 100 exhibited a yield strength of 393MPa.

### <Example 6>

In example 6, the multi-layer aluminum clad sheet 100 which had undergone solution treatment and water cooling at 520 °C for four hours was age-hardened at 160 °C for 18 hours. It could be verified that the resultant multi-layer aluminum clad sheet 100 exhibited a yield strength of 368MPa.

### <Example 7>

In example 7, the multi-layer aluminum clad sheet 100 which had undergone solution treatment and water cooling at 520 °C for four hours was age-hardened at 180 °C for 8 hours. It could be verified that the resultant multi-layer aluminum clad sheet 100 exhibited a yield strength of 333MPa.

### <Example 8>

In example 8, the multi-layer aluminum clad sheet 100 which had undergone solution treatment and water cooling at 520 °C for four hours was subjected to first age-hardening at 80 °C for 16 hours. After the first age hardening, second age hardening was performed at 150 °C for 24 hours. It could be verified that the resultant multi-layer aluminum clad sheet 100 exhibited a yield strength of 410MPa.

The comparison examples in Table 2 are ones obtained by testing under different conditions from examples 1 to 8. A multi-layer aluminum clad sheet 100 formed as per comparison examples 1 to 3 was subjected to solution treatment and water cooling at 520 °C for four hours. Thereafter, it was subjected to age hardening for different times (e.g., 12 hours, 24 hours, and 18 hours) at various temperatures (e.g., 120 °C, 160 °C, or 180 °C). The results showed that clad sheets manufactured as per the comparison examples had lower yield strengths than those manufactured as per examples of the present disclosure.

As disclosed herein, in one example, the multi-layer aluminum clad sheet 100 uses the 7xxx-series aluminum alloy 110 in the base area and the 6xxx-series aluminum alloy 120, which is anodizable and has high strength, in the coat area. As another example, by performing heat treatment as shown above for examples 1 to 8, the multi-layer aluminum clad sheet 100 may be obtained which has a high yield strength of 400MPa or more and enhanced surface anodizing characteristics.

Table 3 below presents results of analysis using a colorimeter after anodizing a multi-layer aluminum clad sheet 100 according to an example of the present disclosure.

**[Table 3]**

| colorimeter | example | comparison example |
|---|---|---|
| heat treatment | aluminum alloy after anodizing (coat material + base material (A16061+A17075)) | aluminum alloy after anodizing (A17075) |
| L | 86.05 | 86.16 |
| a | -0.14 | -0.32 |
| b | 2.43 | 5.80 |

Referring to Table 3 above, the multi-layer aluminum clad sheet 100 uses the 7xxx-series aluminum alloy 110 in the base area and the 6xxx-series aluminum alloy 120 in the coat area. This multi-layer aluminum clad sheet 100 has superior surface treatment properties to a clad sheet obtained using the 7xxx-series aluminum alloy 110 alone.

For example, analysis of an anodized clad sheet with only the 7xxx-series aluminum alloy 110 using the colorimeter revealed: L=86.16, a=-0.14, and b=2.43. By contrast, analysis of the clad sheet 100 containing the 6xxx-series aluminum alloy 120 in the coat area using the colorimeter showed: L=86.05, a=-0.32, and b=5.80.

Here, L denotes the brightness, a represents red as its positive (+) value increases or green as its negative (-) value increases, b represents yellow as its positive (+) value increases or blue as its negative (-) value increases.

The anodized clad sheet with only the 7xxx-series aluminum alloy 110, as compared with one according an example of the present disclosure, presented relatively large values for a and b. This may cause discolorations after anodizing, which may be undesirable. Thus, according to an example of the present disclosure, a clad sheet 100 containing the 6xxx-series aluminum alloy 120 in the coat area may retain superior surface treatability. But since the clad sheet according to an example of the present disclosure includes the 7xxx-series aluminum alloy 110 in the base area, it may still have a high yield strength.

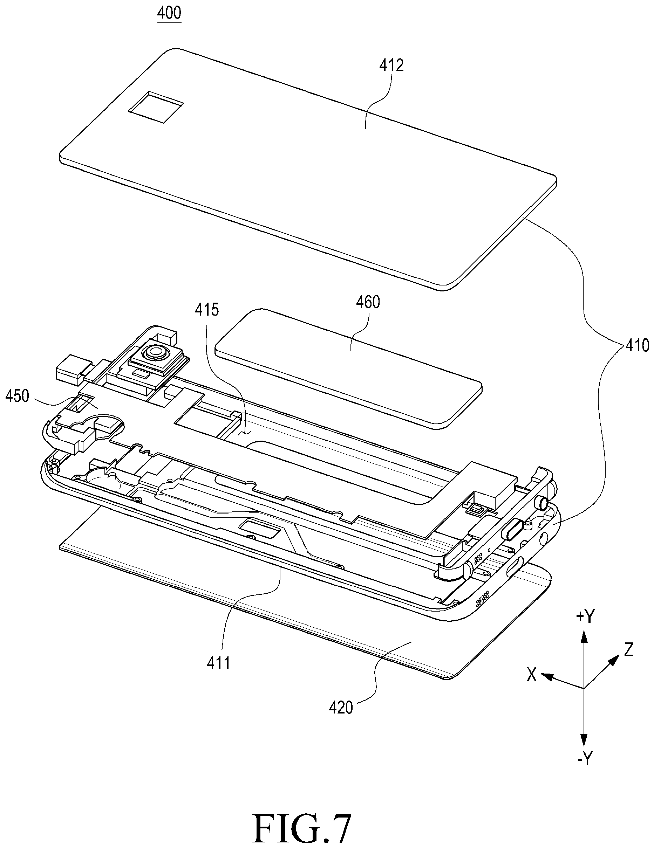

Fig. 7 is an exploded perspective view illustrating an electronic device 400 including a housing 410 made up of an aluminum alloy according to an example of the present disclosure.

Referring to Fig. 7, according to an example of the present disclosure, the electronic device 400 may include the housing 410. The housing 410 includes a front cover 411 facing in a first direction -Y and a rear cover 412 facing in a second direction +Y, i.e. the rear cover 412 is facing the opposite direction as the front cover 411. The front cover 411 may include a transparent area. According to an example of the present disclosure, the electronic device 400 may include a display device 420 that is disposed in the housing 410 and has a screen area exposed through the front cover 411 (e.g. through the transparent area of the front cover 411). The housing 410 is formed of anodizable aluminum alloys. The aluminum alloys may include a base material including a 7xxx-series aluminum alloy as described above and a coat material disposed on one or both surfaces of the base material and including a 6xxx-series aluminum alloy or 1xxx-series aluminum alloy.

According to an example of the present disclosure, the housing 410 may be an element for housing various electronic parts. At least part of the housing 410 may be formed of a conductive material. For example, the housing 410 may include side walls that form the external surface of the electronic device 400. The housing 410 may include a conductive material that is exposed to the exterior of the electronic device 400. The printed circuit board 450 and/or a battery 460 may be housed inside the housing 410. For example, a processor, a communication module, various interfaces, a power management module, and/or a control circuit may be configured in the form of an integrated chip and mounted on the printed circuit board 450. For example, the control circuit may be part of the processor or the communication module.

According to an example of the present disclosure, the display device 420 may include a material that transmits radio waves or magnetic fields. The display device 420 may include a window member formed of reinforced glass and a display panel placed on the inner side surface of the window member. A touch panel may be provided between the window member and the display device. For example, the display device 420 may be utilized as an input device for touchscreen functionality, and not only as an output device for outputting displayed screens.

As set forth above, according to an example of the present disclosure, an anodizable aluminum clad sheet may comprise a base material including a 7xxx-series aluminum alloy and a coat material including a 6xxx-series aluminum alloy or a 1xxx-series aluminum alloy disposed on one or both front and back surfaces of the base material.

The 7xxx-series aluminum alloy may include 4.0% to 8.0% of zinc (Zn) relative to a total weight of the aluminum clad sheet, 1.0% to 3.0% of magnesium (Mg) relative to the total weight of the aluminum clad sheet, and the rest being aluminum (Al) and at least one other impurity.

According to an example of the present disclosure, the 6xxx-series aluminum alloy may include 0.4% to 1.4% of silicon (Si) relative to the total weight of the aluminum clad sheet, 0.6% to 1.3% of magnesium (Mg) relative to the total weight of the aluminum clad sheet, and the rest being aluminum (Al) and at least one other impurity.

According to an example of the present disclosure, the aluminum clad sheet may be rendered to present a yield strength ranging from 330MPa to 450Pa by heat treatment.

According to an example of the present disclosure, the at least one impurity of the 7xxx-series aluminum alloy may be at least one of silicon (Si), iron (Fe), copper (Cu), manganese (Mn), chromium (Cr), and titanium (Ti). 1.0% to 2.0% of Cu may be included relative to the total weight of the aluminum clad sheet.

According to an example of the present disclosure, the at least one impurity of the 6xxx-series aluminum alloy may be at least one of iron (Fe), copper (Cu), manganese (Mn), chromium (Cr), zinc (Zn), and titanium (Ti). 1.0% or less of Cu may be included relative to the total weight of the aluminum clad sheet.

According to an example of the present disclosure, when the 6xxx-series aluminum alloy is used as the coat material, the 6xxx-series aluminum alloy may make up 10% to 50% of the thickness of the entire aluminum clad sheet.

According to an example of the present disclosure, when the 1xxx-series aluminum alloy is used as the coat material, the 1xxx-series aluminum alloy may make up 20% or less of the thickness of the entire aluminum clad sheet.

According to an example of the present disclosure, when the 6xxx-series aluminum alloy is used as the coat material, the 6xxx-series aluminum alloy has a strength of at least 250MPa and the 7xxx-series aluminum alloy has a strength of at least 450MPa. The 6xxx-series aluminum alloy and the 7xxx-series aluminum alloy may be hot-rolled in a reduction ratio ranging from 40% to 60%.

According to an example of the present disclosure, when the 1xxx-series aluminum alloy is used as the coat material, the 1xxx-series aluminum alloy has a strength of at least 450MPa. The 1xxx-series aluminum alloy and the 7xxx-series aluminum alloy may be hot-rolled in a reduction ratio ranging from 10% to 20%.

According to an example of the present disclosure, a layer of the 6xxx-series aluminum alloy having a strength of at least 250MPa may be overlaid on the front surface of a layer of the 7xxx-series aluminum alloy having a strength of at least 450MPa, and a layer of the 1xxx-series aluminum alloy may be overlaid on the back surface of the layer of the 7xxx-series aluminum alloy.

According to an example of the present disclosure, an electronic device including an exterior material made of an aluminum alloy may comprise a housing including a front cover facing in a first direction and a rear cover facing in a second direction opposite to the front cover, the front cover having a transparent area and a display device disposed in the housing and including a screen area exposed through the transparent area of the front cover.

The housing may include a base material including a 7xxx-series aluminum alloy and a coat material including a 6xxx-series aluminum alloy or a 1xxx-series aluminum alloy disposed on one or both front and back surfaces of the base material, wherein the 7xxx-series aluminum alloy includes 4.0% to 8.0% of zinc (Zn) relative to a total weight of the aluminum alloy, 1.0% to 3.0% of magnesium (Mg) relative to the total weight of the aluminum alloy, and the rest being aluminum (Al) and at least one other impurity.

According to an example of the present disclosure, a method for manufacturing an aluminum clad sheet which is anodizable may comprise preparing a 7xxx-series aluminum alloy and a 6xxx-series aluminum alloy or a 1xxx-series aluminum alloy, placing the 7xxx-series aluminum alloy as a base material and overlaying the 6xxx-series aluminum alloy or the 1xxx-series aluminum alloy, as a coat material, on one or both front or back surfaces of the base material, and heating the base material and the coat material at 480 °C to 520 °C to soften and rolling the softened base material and coat material so that the base material and the coat material are joined together.

According to an example of the present disclosure, the method may further comprise forging and shaping the base material and coat material, performing solution treatment on the aluminum clad sheet, the solution treatment including heating the aluminum clad sheet at 520 °C to 540 °C for 30 minutes or more and then water cooling the aluminum clad sheet, and performing age-hardening on the solution-treated aluminum clad sheet, the age-hardening including heating the aluminum clad sheet at the solution-treated layers at 80 °C to 180 °C for eight hours or more and then air cooling the aluminum clad sheet.

According to an example of the present disclosure, the 7xxx-series aluminum alloy may have a yield strength of 450MPa or more, and the 6xxx-series aluminum alloy may have a yield strength of 250MPa or more.

According to an example of the present disclosure, heating the base material and the coat material to soften may include heating the base material and the coat material at 480 °C to 520 °C for 0.5 hours to 1.5 hours.

According to an example of the present disclosure, base material and the coat material may be joined together by heating the base material and the coat material at 480 °C to 520 °C for 15 minutes or more to lead to interfacial diffusion bonding. The base material and the coat material may be hot-rolled in a reduction ratio ranging from 40% to 60%.

According to an example of the present disclosure, the base material and the coat material may be repeatedly heated and rolled to achieve a reduction ratio of 40% or more.

According to an example of the present disclosure, the base material and the coat material may be repeatedly heated and rolled to achieve a reduction ratio of 10% to 20%.

According to an example of the present disclosure, forging and shaping the softened base material and coat material may include heating the base material and the coat material for five minutes or more after forging and then re-forging and re-shaping the base material and the coat material.

According to an example of the present disclosure, the solution treatment may include heating the aluminum clad sheet at 500 °C to 540 °C for 3.5 hours to 4.5 hours and then water cooling the aluminum clad sheet.

According to an example of the present disclosure, the age hardening may include heating the solution-treated aluminum clad sheet at 60 °C to 100 °C for 12 hours to 20 hours, reheating the heated aluminum clad sheet at 120 °C to 180 °C for 18 hours to 30 hours, and then air cooling the aluminum clad sheet.

According to an example of the present disclosure, the aluminum clad sheet may be rendered to present a yield strength ranging from 330MPa to 450Pa by heat treatment.

As is apparent from the foregoing description, according to an example of the present disclosure, a clad sheet may use a 7xxx-series aluminum alloy in the base area to have a higher strength and a 1xxx-series aluminum alloy having superior anodizing properties or a 6xxx-series aluminum alloy which is also anodizable in the coat area. Thus, an aluminum clad sheet may be produced which has a high yield strength of 400MPa or more along with superior surface anodizing properties.

According to an example of the present disclosure, a method for manufacturing an aluminum clad sheet may enhance the adhesion strength of the clad sheet by employing thermal treatment after forming the clad sheet and may age-harden the clad sheet without deteriorating strength, thereby achieving superior surface and engineering properties.

## Claims

1. An electronic device, comprising:
a housing formed of an aluminum clad sheet which is anodizable, the aluminum clad sheet comprising:
a base material including a 7xxx-series aluminum alloy; and
a coat material including a 6xxx-series aluminum alloy or a 1xxx-series aluminum alloy disposed on one or both front and back surfaces of the base material, wherein the 7xxx-series aluminum alloy includes 4.0% to 8.0% of zinc (Zn) relative to a total weight of the aluminum clad sheet, 1.0% to 3.0 % of magnesium (Mg) relative to the total weight of the aluminum clad sheet, aluminum (Al), and at least one impurity.

2. The electronic device of claim 1, wherein the 6xxx-series aluminum alloy includes 0.4% to 1.4% of silicon (Si) relative to the total weight of the aluminum clad sheet, 0.6 % to 1.3 % of magnesium (Mg) relative to the total weight of the aluminum clad sheet, aluminum (Al), and at least one impurity.

3. The electronic device of claim 2, wherein the aluminum clad sheet is rendered by heat treatment to exhibit a yield strength ranging from 330MPa to 450MPa by heating the base material and the coat material at 480 °C to 520 °C to soften, rolling the softened base material and coat material so that the base material and the coat material are joined together, forging and shaping the base material and coat material, performing solution treatment on the aluminum clad sheet, the solution treatment including heating the aluminum clad sheet at 520 °C to 540 °C for 30 minutes or more and then water cooling the aluminum clad sheet, and performing age-hardening on the solution-treated aluminum clad sheet, the age-hardening including heating the aluminum clad sheet at the solution-treated layers at 80 °C to 180 °C for eight hours or more and then air cooling the aluminum clad sheet.

4. The electronic device of claim 2, wherein the at least one impurity of the 7xxx-series aluminum alloy is at least one of silicon (Si), iron (Fe), copper (Cu), manganese (Mn), chromium (Cr), and titanium (Ti), and wherein the 7xxx-series aluminum alloy includes 1.0% to 2.0% of Cu relative to the total weight of the aluminum clad sheet.

5. The electronic device of claim 2, wherein the at least one impurity of the 6xxx-series aluminum alloy is at least one of iron (Fe), copper (Cu), manganese (Mn), chromium (Cr), zinc (Zn), and titanium (Ti), and wherein the 6xxx-series aluminum alloy includes 1.0% or less of Cu relative to the total weight of the aluminum clad sheet.

6. The electronic device of claim 3, wherein when the 6xxx-series aluminum alloy is used as the coat material, the 6xxx-series aluminum alloy makes up 10% to 50% of a thickness of the aluminum clad sheet.

7. The electronic device of claim 3, wherein when the 1xxx-series aluminum alloy is used as the coat material, the 1xxx-series aluminum alloy makes up 20% or less of a thickness of the aluminum clad sheet.

8. The electronic device of claim 2, wherein when the 6xxx-series aluminum alloy is used as the coat material, the 6xxx-series aluminum alloy has a strength of at least 250MPa and the 7xxx-series aluminum alloy has a strength of at least 450MPa, and wherein the 6xxx-series aluminum alloy and the 7xxx-series aluminum alloy are hot-rolled in a reduction ratio ranging from 40% to 60%.

9. The electronic device of claim 2, wherein when the 1xxx-series aluminum alloy is used as the coat material, the 1xxx-series aluminum alloy has a strength of at least 450MPa, and wherein the 1xxx-series aluminum alloy and the 7xxx-series aluminum alloy are hot-rolled in a reduction ratio ranging from 10% to 20%.

10. The electronic device of claim 2, wherein a layer of the 6xxx-series aluminum alloy having a strength of at least 250MPa is overlaid on the front surface of a layer of the 7xxx-series aluminum alloy having a strength of at least 450MPa, and a layer of the 1xxx-series aluminum alloy is overlaid on the back surface of the layer of the 7xxx-series aluminum alloy.

## Patentansprüche

1. Elektronische Vorrichtung, umfassend:
ein aus einer Aluminiumplattierungslage gebildetes, anodisierbares Gehäuse, wobei die Aluminiumplattierungslage folgendes umfasst:
ein Basismaterial, das eine Aluminiumlegierung der 7xxx-Serie umfasst; und
ein Überzugsmaterial, das eine Aluminiumlegierung der 6xxx-Serie oder eine Aluminiumlegierung der 1xxx-Serie umfasst, das auf einer oder beiden Seiten einer Vorder- und Rückseite des Basismaterials angeordnet ist, wobei die Aluminiumlegierung der 7xxx-Serie 4,0% bis 8,0% Zink (Zn) im Verhältnis zu einem Gesamtgewicht der Aluminiumplattierungslage umfasst, 1,0% bis 3,0% Magnesium (Mg) im Verhältnis zu dem Gesamtgewicht der Aluminiumplattierungslage, Aluminium (Al) und mindestens eine Unreinheit.

2. Elektronische Vorrichtung nach Anspruch 1, wobei die Aluminiumlegierung der 6xxx-Serie 0,4% bis 1,4% Silizium (Si) im Verhältnis zu dem Gesamtgewicht der Aluminiumplattierungslage, 0,6% bis 1,3% Magnesium (Mg) im Verhältnis zu dem Gesamtgewicht der Aluminiumplattierungslage, Aluminium (Al) und mindestens eine Unreinheit umfasst.

3. Elektronische Vorrichtung nach Anspruch 2, wobei der Aluminiumplattierungslage durch Wärmebehandlung eine Streckfestigkeit von 330 MPa bis 450 MPa verliehen wird durch Erhitzen des Basismaterials und des Überzugsmaterials auf 480 °C bis 520 °C, um das erweichte Basismaterial und Überzugsmaterial zu walzen, so dass das Basismaterial und das Überzugsmaterial miteinander verbunden werden, das Basismaterial und das Überzugsmaterial geschmiedet und geformt werden, wobei eine Lösungsbehandlung an der Aluminiumplattierungslage durchgeführt wird, wobei die Lösungsbehandlung das Erhitzen der Aluminiumplattierungslage über 30 Minuten oder länger bei 520 °C bis 540° erhitzt wird, und wobei die Aluminiumplattierungslage danach mit Wasser gekühlt wird, und wobei eine Alterungshärtung an der lösungsbehandelten Aluminiumplattierungslage an den lösungsbehandelten Schichten über acht Stunden oder länger bei 80 °C bis 180 °C durchgeführt wird, und wobei die Aluminiumplattierungslage danach luftgekühlt wird.

4. Elektronische Vorrichtung nach Anspruch 2, wobei die mindestens eine Unreinheit der Aluminiumlegierung der 7xxx-Serie mindestens eines der folgenden ist: Silizium (Si), Eisen (Fe), Kupfer (Cu), Mangan (Mn), Chrom (Cr) und Titan (Ti), und wobei die Aluminiumlegierung der 7xxx-Serie 1,0% bis 2,0% Cu im Verhältnis zu dem Gesamtgewicht der Aluminiumplattierungslage umfasst.

5. Elektronische Vorrichtung nach Anspruch 2, wobei die mindestens eine Unreinheit der Aluminiumlegierung der 6xxx-Serie mindestens eines der folgenden ist: Eisen (Fe), Kupfer (Cu), Mangan (Mn), Chrom (Cr), Zink (Zn) und Titan (Ti), und wobei die Aluminiumlegierung der 6xxx-Serie 1,0% oder weniger Cu im Verhältnis zu dem Gesamtgewicht der Aluminiumplattierungslage umfasst.

6. Elektronische Vorrichtung nach Anspruch 3, wobei, wenn die Aluminiumlegierung der 6xxx-Serie als Überzugsmaterial verwendet wird, die Aluminiumlegierung der 6xxx-Serie 10% bis 50% einer Dicke der Aluminiumplattierungslage ausmacht.

7. Elektronische Vorrichtung nach Anspruch 3, wobei, wenn die Aluminiumlegierung der 1xxx-Serie als Überzugsmaterial verwendet wird, die Aluminiumlegierung der 1xxx-Serie 20% oder weniger einer Dicke der Aluminiumplattierungslage ausmacht.

8. Elektronische Vorrichtung nach Anspruch 2, wobei, wenn die Aluminiumlegierung der 6xxx-Serie als Überzugsmaterial verwendet wird, die Aluminiumlegierung der 6xxx-Serie eine Festigkeit von mindestens 250 MPa aufweist, und wobei die Aluminiumlegierung der 7xxx-Serie eine Festigkeit von mindestens 450 MPa aufweist, und wobei die Aluminiumlegierung der 6xxx-Serie und die Aluminiumlegierung der 7xxx-Serie in einem Reduktionsverhältnis von 40% bis 60% warmgewalzt werden.

9. Elektronische Vorrichtung nach Anspruch 2, wobei, wenn die Aluminiumlegierung der 1xxx-Serie als Überzugsmaterial verwendet wird, die Aluminiumlegierung der 1xxx-Serie eine Festigkeit von mindestens 450 MPa aufweist, und wobei die Aluminiumlegierung der 1xxx-Serie und die Aluminiumlegierung der 7xxx-Serie in einem Reduktionsverhältnis von 10% bis 20% warmgewalzt werden.

10. Elektronische Vorrichtung nach Anspruch 2, wobei eine Schicht der Aluminiumlegierung der 6xxx-Serie mit einer Festigkeit von mindestens 250 MPa die Vorderseite einer Schicht der Aluminiumlegierung der 7xxx-Serie mit einer Festigkeit von mindestens 450 MPa überlagert, und wobei eine Schicht der Aluminiumlegierung der 1xxx-Serie die Rückseite der Schicht der Aluminiumlegierung der 7xxx-Serie überlagert.

## Revendications

1. Dispositif électronique comprenant :
un boîtier formé d'une tôle plaquée d'aluminium qui peut être anodisée, la tôle plaquée d'aluminium comprenant :
un matériau de base comprenant un alliage d'aluminium de la série 7xxx ; et
un matériau de revêtement comprenant un alliage d'aluminium de la série 6xxx ou un alliage d'aluminium de la série 1xxx disposé sur une ou les deux surfaces avant et arrière du matériau de base, l'alliage d'aluminium de la série 7xxx comprenant de 4,0 % à 8,0 % de zinc (Zn) par rapport à un poids total de la tôle plaquée d'aluminium, de 1,0 % à 3,0 % de magnésium (Mg) par rapport au poids total de la tôle plaquée d'aluminium, de l'aluminium (Al), et au moins une impureté.

2. Dispositif électronique selon la revendication 1, l'alliage d'aluminium de la série 6xxx comprenant de 0,4 % à 1,4 % de silicium (Si) par rapport au poids total de la tôle plaquée d'aluminium, de 0,6 % à 1,3 % de magnésium (Mg) par rapport au poids total de la tôle plaquée d'aluminium, de l'aluminium (Al), et au moins une impureté.

3. Dispositif électronique selon la revendication 2, la tôle plaquée d'aluminium étant rendue par traitement thermique pour présenter une limite d'élasticité comprise entre 330 MPa et 450 MPa en chauffant le matériau de base et le matériau de revêtement à 480 °C à 520 °C pour ramollir, en laminant le matériau de base et le matériau de revêtement ramollis de sorte que le matériau de base et le matériau de revêtement soient joints ensemble, en forgeant et en façonnant le matériau de base et le matériau de revêtement, en effectuant un traitement de mise en solution sur la tôle plaquée d'aluminium, le traitement de mise en solution comprenant le chauffage de la tôle plaquée d'aluminium de 520 °C à 540 °C pendant 30 minutes ou plus, puis le refroidissement à l'eau de la tôle plaquée d'aluminium, et en effectuant le durcissement par vieillissement de la tôle plaquée d'aluminium traitée par mise en solution, le durcissement par vieillissement comprenant le chauffage de la tôle plaquée d'aluminium au niveau des couches traitées par mise en solution à 80 °C à 180 °C pendant huit heures ou plus, puis le refroidissement à l'air de la tôle plaquée d'aluminium.

4. Dispositif électronique selon la revendication 2, l'au moins une impureté de l'alliage d'aluminium de la série 7xxx étant du silicium (Si), du fer (Fe), du cuivre (Cu), du manganèse (Mn), du chrome (Cr) et/ou du titane (Ti), et l'alliage d'aluminium de la série 7xxx comprenant de 1,0 % à 2,0 % de Cu par rapport au poids total de la tôle plaquée d'aluminium.

5. Dispositif électronique selon la revendication 2, l'au moins une impureté de l'alliage d'aluminium de la série 6xxx étant du fer (Fe), du cuivre (Cu), du manganèse (Mn), du chrome (Cr), du zinc (Zn) et/ou du titane (Ti), et l'alliage d'aluminium de la série 6xxx comprenant 1,0 % ou moins de Cu par rapport au poids total de la tôle plaquée d'aluminium.

6. Dispositif électronique selon la revendication 3, lorsque l'alliage d'aluminium de la série 6xxx est utilisé comme matériau de revêtement, l'alliage d'aluminium de la série 6xxx représentant de 10 % à 50 % de l'épaisseur de la tôle plaquée d'aluminium.

7. Dispositif électronique selon la revendication 3, lorsque l'alliage d'aluminium de la série 1xxx est utilisé comme matériau de revêtement, l'alliage d'aluminium de la série 1xxx représentant 20 % ou moins d'une épaisseur de la tôle plaquée d'aluminium.

8. Dispositif électronique selon la revendication 2, lorsque l'alliage d'aluminium de la série 6xxx est utilisé comme matériau de revêtement, l'alliage d'aluminium de la série 6xxx ayant une résistance d'au moins 250 MPa et l'alliage d'aluminium de la série 7xxx ayant une résistance d'au moins 450 MPa, et l'alliage d'aluminium de la série 6xxx et l'alliage d'aluminium de la série 7xxx étant laminés à chaud dans un rapport de réduction compris entre 40 % et 60 %.

9. Dispositif électronique selon la revendication 2, lorsque l'alliage d'aluminium de la série 1xxx est utilisé comme matériau de revêtement, l'alliage d'aluminium de la série 1xxx ayant une résistance d'au moins 450 MPa, et l'alliage d'aluminium de la série 1xxx et l'alliage d'aluminium de la série 7xxx étant laminés à chaud dans un rapport de réduction compris entre 10 % et 20 %.

10. Dispositif électronique selon la revendication 2, une couche de l'alliage d'aluminium de la série 6xxx ayant une résistance d'au moins 250 MPa est superposée sur la surface avant d'une couche de l'alliage d'aluminium de la série 7xxx ayant une résistance d'au moins 450 MPa, et une couche de l'alliage d'aluminium de la série 1xxx étant superposée sur la surface arrière de la couche de l'alliage d'aluminium de la série 7xxx.
